# EUROPEAN PATENT APPLICATION

(11) **EP 4 815 663 A1**
(43) Date of publication of application: **30.09.2026**
(21) Application number: 25897553.1
(22) Date of filing: 27.11.2025
(51) Int. Cl.: H10D 8/50, H10D 8/01

(54) **GALLIUM OXIDE VERTICAL DEVICE AND PREPARATION METHOD THEREFOR**

(30) Priority: 29.11.2024 CN 202411756344
(71) Applicant: Suzhou Institute of Nano-Tech and Nano-Bionics (SINANO), Chinese Academy of Sciences, Suzhou, Jiangsu 215123 (CN)
(72) Inventor: ZHANG, Xiaodong, Suzhou, Jiangsu 215123 (CN); HU, Yu, Suzhou, Jiangsu 215123 (CN); ZHANG, Li, Suzhou, Jiangsu 215123 (CN); CENG, Chunhong, Suzhou, Jiangsu 215123 (CN); CENG, Zhongming, Suzhou, Jiangsu 215123 (CN); ZHANG, Baoshun, Suzhou, Jiangsu 215123 (CN)
(74) Representative: Bayramoglu et al.
(86) International application number: PCT/CN2025/138197
(87) International publication number: WO 2026/114316

(57) **Abstract**

Provided are a vertical-type gallium oxide device and a fabrication method therefor. The vertical-type gallium oxide device includes an epitaxial structure, and a cathode and an anode that are matched to the epitaxial structure, where the epitaxial structure includes a heavily doped n-type Ga₂O₃ substrate, a lightly doped n-type Ga₂O₃ drift region, an interlayer, and a p-type nitride epitaxial layer that are arranged in a stacked sequence. The lightly doped n-type Ga₂O₃ drift region, the interlayer and the p-type nitride epitaxial layer form a p-i-n structure, the cathode forms an ohmic contact with the heavily doped n-type Ga₂O₃ substrate, and the anode forms an ohmic contact with the p-type nitride epitaxial layer. The interlayer is made of an Al-containing compound, and a surface region that is of the lightly doped n-type Ga₂O₃ drift region and that is close to the interlayer also contains an Al element, where the Al element is diffused from the interlayer into the lightly doped n-type Ga₂O₃ drift region during high-pressure bonding.

## Description

This patent application is based on and claims the priority of Chinese Patent Application No. 202411756344.5 filed with the China National Intellectual Property Administration on November 29, 2024 and entitled "Vertical-type gallium oxide device and fabrication method therefor".

### TECHNICAL FIELD

The present disclosure particularly relates to a vertical-type gallium oxide device and a fabrication method therefor, belonging to the technical field of semiconductors.

### BACKGROUND TECHNOLOGY

At current, power semiconductor devices third- generation wide bandgap semiconductor gallium nitride materials have been widely studied and applied. Due to excellent material characteristics of the gallium nitride material such as large bandgap (3.4 eV) and high thermal conductivity, its power semiconductor device has high breakthrough voltage, and can be applied in a harsh environment such as high temperature and strong radiation. However, large-scale mass production of vertical-type gallium nitride transistors is difficult to achieve due to influence of high cost of a free-standing substrate of the gallium nitride.

Gallium oxide exists in various crystal phases, including α, β, γ, δ, and ε, where β- Ga₂O₃ exhibits the highest thermal stability and is a stable phase of the other four structures at a high temperature. Therefore, β- Ga₂O₃ material is the primary focus in research for high-power applications. β- Ga₂O₃ has an ultra-wide bandgap (4.8 to 4.9 eV) and a breakdown field strength of up to 7 to 8 MV/cm. In addition, the gallium oxide has a large-sized free-standing substrate, making it promising for large- scale device mass production. However, the gallium oxide suffers from low thermal conductivity.

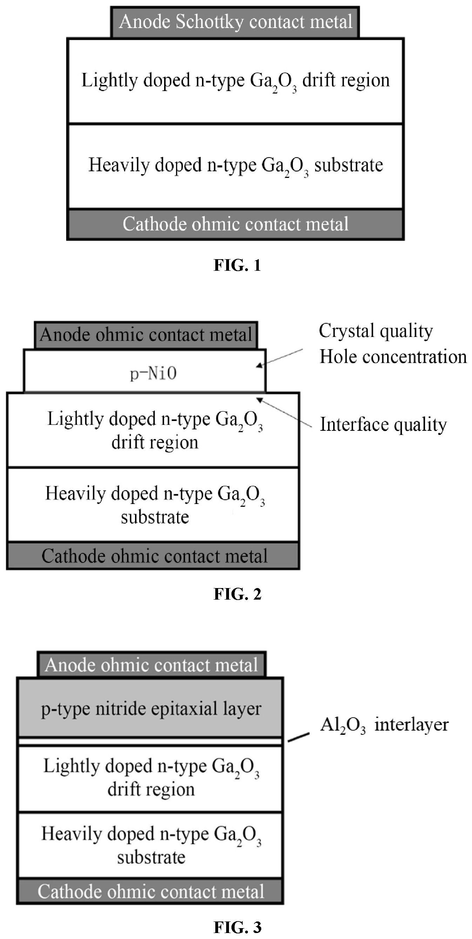

However, there has been insufficient research on p- type doping of gallium oxide using existing techniques, resulting in inability to fabricate gallium oxide pn junction diodes. Consequently, most studies have merely achieved Schottky diodes (FIG. 1). Although there have been reports on constructing pn heterojunctions using p-type oxides such as p-NiO with n- Ga₂O₃ (FIG. 2), commonly employed methods include sol-gel, sputtering, and the like, problems still exist in the crystal quality and hole concentration of p-NiO, and material interface properties need to be improved, resulting in the failure to achieve theoretical advantages of Ga₂O₃. Although there have also been reports on the epitaxy of Ga₂O₃ on GaN, different crystal structures and lattice mismatch between the Ga₂O₃ and the GaN result in failure to obtain a high-quality heteroepitaxial film.

Generally speaking, to solve the difficulty in achieving p-type doping in Ga₂O₃ in the prior art, pn junctions are formed by a method for constructing the pn heterojunction. However, most of the reported structures and process solutions such as p-type oxide heterojunctions still exhibit problems in crystal quality and material properties. In contrast, mechanical exfoliation of Ga₂O₃ is merely applicable to laboratory fabrication. In addition, devices fabricated via high-temperature bonding still face numerous challenges in performance and reliability, and high-temperature processing may degrade process compatibility.

### CONTENT OF THE INVENTION

A main objective of the present disclosure is to provide a vertical-type gallium oxide device and a fabrication method therefor, thereby solving disadvantages in the prior art.

To implement the foregoing objective, the technical solution adopted by the present disclosure includes:
A first objective of an embodiment of the present disclosure provides a vertical-type gallium oxide device, including an epitaxial structure, and a cathode and an anode that are matched to the epitaxial structure, where the epitaxial structure includes a heavily doped n-type Ga₂O₃ substrate, a lightly doped n-type Ga₂O₃ drift region, an interlayer, and a p-type nitride epitaxial layer that are arranged in a stacked sequence; the lightly doped n-type Ga₂O₃ drift region, the interlayer and the p-type nitride epitaxial layer form a p-i-n structure, the cathode forms an ohmic contact with the heavily doped n-type Ga₂O₃ substrate, and the anode forms an ohmic contact with the p-type nitride epitaxial layer; the interlayer includes an Al-containing compound, and a surface region that is of the lightly doped n-type Ga₂O₃ drift region and that is close to the interlayer also contains an Al element, where the Al element is diffused from the interlayer into the lightly doped n-type Ga₂O₃ drift region during high-pressure bonding.
A second aspect of the embodiment of the present disclosure provides a fabrication method for a vertical-type gallium oxide device, including the following steps:
   providing a first epitaxial structure, where the first epitaxial structure includes a heavily doped n-type Ga₂O₃ substrate, a lightly doped n-type Ga₂O₃ drift region, and an interlayer that are arranged in a stacked manner, and the interlayer includes an Al-containing compound;
   providing a second epitaxial structure, where the second epitaxial structure includes a p-type nitride epitaxial layer, and carrying out plasma surface activation treatment on the p-type nitride epitaxial layer;
   directly bonding an interlayer of the first epitaxial structure to the p-type nitride epitaxial layer of the second epitaxial structure, where the lightly doped n-type Ga₂O₃ drift region, the interlayer, and the p-type nitride epitaxial layer form a p-i-n structure, and during bonding, a part of Al in the interlayer is diffused into a surface region that is of the lightly doped n-type Ga₂O₃ drift region and that is close to the interlayer; and
   forming a cathode on a back surface of the heavily doped n-type Ga₂O₃ substrate, and forming an anode on a surface of the p-type nitride epitaxial layer.

Compared with the prior art, the present disclosure has advantages as follows:
According to the present disclosure, a high-quality p-type nitride layer and a high-quality n-type gallium oxide layer are epitaxially grown separately, and then a high-quality p-type nitride/n-type gallium oxide heterojunction material structure and a pn heterojunction device are achieved by low-temperature bonding. The device features excellent process compatibility, can achieve large-scale device fabrication, and improves uniformity and reliability of the device.
According to the present disclosure, a gallium oxide pn heterojunction diode can be effectively achieved. For both p-type and n-type epitaxial layers, high quality and controllable epitaxy can be achieved, thereby avoiding device uniformity and reliability problems caused by insufficient crystal quality, poor controllability, and other related problems. A low-temperature bonding process ensures strong process compatibility. As the p-type nitride epitaxial layer can be epitaxially grown over a large area on a Si substrate, efficient large-scale device fabrication can be achieved. The method for forming the pn heterojunction is flexible and convenient, enabling implementation of a complex device structure.
According to the present disclosure, during high-pressure bonding, the Al₂O₃/AlN interlayer releases Al atoms that diffuse into the lightly doped n-type Ga₂O₃ drift region. This not only improves bonding interface quality but also increases a carrier concentration and reduces on-resistance of the device. In addition, a depletion region is further expanded, thereby enhancing voltage withstand performance of the device.

### DESCRIPTION OF THE DRAWINGS

FIG. 1 is a diagram of a structure of a conventional Schottky diode;
FIG. 2 is a diagram of a structure of a conventional p-NiO/n-Ga₂O₃ heterojunction;
FIG. 3 is a diagram of a structure of a vehicle-type gallium oxide device according to a typical embodiment of the present disclosure;
FIG. 4a, FIG. 4b, FIG. 4c, FIG. 5a, FIG. 5b, FIG. 6a, FIG. 6b, FIG. 6c, and FIG. 6d each are a diagram of a structure of an epitaxial structure intermediate formed in a fabrication process of a vehicle-type gallium oxide device according to a typical embodiment of the present disclosure;
FIG. 7 is a diagram of a structure of another vehicle-type gallium oxide device according to a typical embodiment of the present disclosure.

### SPECIFIC IMPLEMENTATIONS

In view of deficiencies in the prior art, the inventors of the present disclosure have been able to propose the technical solutions of the present disclosure through long-term research and numerous practices. The technical solution, implementations and principle of the present disclosure are further swollen and described below.

A first objective of an embodiment of the present disclosure provides a vertical-type gallium oxide device, including an epitaxial structure, and a cathode and an anode that are matched to the epitaxial structure. The epitaxial structure includes a heavily doped n-type Ga₂O₃ substrate, a lightly doped n-type Ga₂O₃ drift region, an interlayer, and a p-type nitride epitaxial layer that are arranged in a stacked sequence. The lightly doped n-type Ga₂O₃ drift region, the interlayer and the p-type nitride epitaxial layer form a p-i-n structure, the cathode forms an ohmic contact with the heavily doped n-type Ga₂O₃ substrate, and the anode forms an ohmic contact with the p-type nitride epitaxial layer. The interlayer includes an Al-containing compound, and a surface region that is of the lightly doped n-type Ga₂O₃ drift region and that is close to the interlayer also contains an Al element, where the Al element is diffused from the interlayer into the lightly doped n-type Ga₂O₃ drift region during high-pressure bonding.

Further, the interlayer is an Al₂O₃ interlayer or an AlN interlayer.

Further, the interlayer has a thickness of 1 nm to 5 nm.

Further, the p-type nitride epitaxial layer includes at least one or a combination of two or more of p-GaN, p-AlGaN, and p-InGaN.

Further, the p-type nitride epitaxial layer has a thickness of 10 nm to 1 µm.

Further, p-type impurities in the p-type nitride epitaxial layer are in uniform distribution or gradient distribution.

Further, a doping concentration of the p-type impurities in the p-type nitride epitaxial layer gradually decreases from one side that is of the p-type nitride epitaxial layer and that is close to the interlayer to one side that is close to the anode.

Further, a dielectric layer is further disposed between the p-type nitride epitaxial layer and the anode, the dielectric layer includes any one or a combination of two or more of AlN, Al₂O₃, and BN, and the dielectric layer has a thickness of 1 nm to 10 nm.

Further, the vertical-type gallium oxide device may be a diode or a transistor.

A second aspect of the embodiment of the present disclosure provides a fabrication method for a vertical-type gallium oxide device, including the following steps.

Provide a first epitaxial structure, where the first epitaxial structure includes a heavily doped n-type Ga₂O₃ substrate, a lightly doped n-type Ga₂O₃ drift region, and an interlayer that are arranged in a stacked manner, and the interlayer includes an Al-containing compound.

Provide a second epitaxial structure, where the second epitaxial structure includes a p-type nitride epitaxial layer, and carry out plasma surface activation treatment on the p-type nitride epitaxial layer.

Directly bond an interlayer of the first epitaxial structure to the p-type nitride epitaxial layer of the second epitaxial structure, where the lightly doped n-type Ga₂O₃ drift region, the interlayer, and the p-type nitride epitaxial layer form a p-i-n structure, and during bonding, a part of Al in the interlayer is diffused into a surface region that is of the lightly doped n-type Ga₂O₃ drift region and that is close to the interlayer.

Form a cathode on a back surface of the heavily doped n-type Ga₂O₃ substrate, and form an anode on a surface of the p-type nitride epitaxial layer.

In a specific implementation, a fabrication method for the vertical-type gallium oxide device includes the following steps.

Provide a first substrate, grow a nitride buffer layer on the first substrate, grow a p-type nitride epitaxial layer on the nitride buffer layer, form a first insulating dielectric layer on the p-type nitride epitaxial layer, and form a first metallic layer on the first insulating dielectric layer.

Provide a second substrate, form a second insulating dielectric layer on the second substrate, and form a second metallic layer on the second insulating dielectric layer.

Integrally bond the first metallic layer and the second metallic layer.

Remove the first substrate and the nitride buffer layer, and take a remaining portion as the second epitaxial structure.

After directly bond the interlayer of the first epitaxial structure to the p-type nitride epitaxial layer of the second epitaxial structure, remove a portion of the second epitaxial structure other than the p-type nitride epitaxial layer.

Further, the interlayer is an Al₂O₃ interlayer or an AlN interlayer.

Further, the interlayer has a thickness of 1 nm to 5 nm.

Further, the fabrication method specifically includes: form a lightly doped n-type Ga₂O₃ drift region on a heavily doped n-type Ga₂O₃ substrate, form an Al layer on the lightly doped n-type Ga₂O₃ drift region, and oxidize the Al layer to form an Al₂O₃ interlayer.

Further, the p-type nitride epitaxial layer includes at least one or a combination of two or more of p-GaN, p-AlGaN, and p-InGaN.

Further, the p-type nitride epitaxial layer has a thickness of 10 nm to 1 µm.

Further, p-type impurities in the p-type nitride epitaxial layer are in uniform distribution or gradient distribution.

Further, a doping concentration of the p-type impurities in the p-type nitride epitaxial layer gradually decreases from one side that is of the p-type nitride epitaxial layer and that is close to the interlayer to one side that is close to the anode.

Further, the fabrication method for the vertical-type gallium oxide device further includes: fabricate a dielectric layer on the p-type nitride epitaxial layer, and then fabricate an anode on the dielectric layer, where the dielectric layer includes any one or a combination of two or more of AlN, Al₂O₃, and BN, and the dielectric layer has a thickness of 1 nm to 10 nm.

The technical solutions, implementations and principle of the present disclosure are further explained and described below with reference to accompanying drawings and specific embodiments. Unless otherwise specified, semiconductor epitaxial growth equipment and processes thereof, bonding equipment and processes thereof, metal deposition equipment and processes thereof, and the like, used in the embodiments of the present disclosure are all known in the art.

In a relatively specific implementation, with reference to FIG. 3, a vertical-type gallium oxide device includes a cathode ohmic contact metal (that is a cathode, the same hereinafter), a heavily doped n-type Ga₂O₃ substrate, a lightly doped n-type Ga₂O₃ drift region, an intrinsic Al₂O₃ interlayer, a p-type nitride epitaxial layer, and an anode ohmic contact metal (that is an anode, the same hereinafter) from bottom to top. The p-type nitride epitaxial layer forms a pn junction with the n-type Ga₂O₃ layer. When a forward voltage is applied to the anode, a depletion region of the pn junction narrows, generating a forward on-state current, and the device is in an on state. When a reverse voltage is applied to the anode, the depletion region of the pn junction widens, without current generated, and the device is in an off state.

Specifically, the lightly doped n-type Ga₂O₃ drift region has a thickness of 200 nm, the p-type nitride epitaxial layer has a thickness of 10 nm to 1 µm, the p-type nitride epitaxial layer includes at least one or a combination of two or more of p-GaN, p-AlGaN, and p-InGaN, and the Al₂O₃ interlayer or the AlN interlayer has a thickness of 1 nm to 5 nm. The cathode ohmic contact metal and the anode ohmic contact metal may be Ti/Au=50/100 nm.

Specifically, the vertical-type gallium oxide device may further include a junction termination structure, such as a high-resistance junction termination, a field plate, and a field limiting ring.

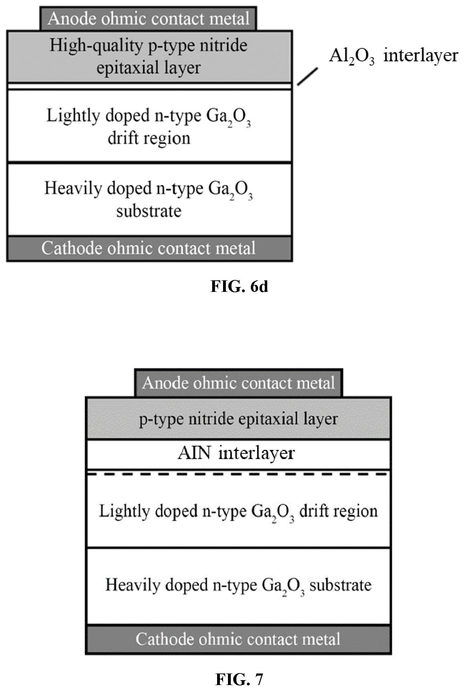

In a relatively specific implementation, with reference to FIG. 7, the intrinsic Al₂O₃ interlayer in the vertical-type gallium oxide device may also be replaced with an AlN interlayer. Specifically, the choice of Al₂O₃ or AlN as the interlayer may be determined according to specific device requirements and operating environments.

Specifically, the Al₂O₃ interlayer/AlN interlayer is used as an intrinsic layer of a p-i-n structure, which is formed by the lightly doped n-type Ga₂O₃ drift region, the interlayer, and the p-type nitride epitaxial layer. The Al₂O₃ interlayer/AlN interlayer improves voltage withstand capacity of the device by increasing a width of the depletion region, and extends a depth of the depletion region by providing a non-conductive region, so that the device can avoid breakdown and maintain favorable performance under a high reverse voltage. In addition to widening the depletion region, the Al₂O₃ layer may also improve quality of an interface between p-GaN and n-Ga₂O₃. Al₂O₃ exhibits good lattice matching with both Ga₂O₃ and GaN, which helps reduce interface defect density and further enhances the stability and voltage withstand capacity of the device. During high-pressure bonding, the Al₂O₃ interlayer/AlN interlayer may release Al elements that diffuse into the lightly doped n-type Ga₂O₃ drift region. This is highly beneficial for improving quality of a bonding interface.

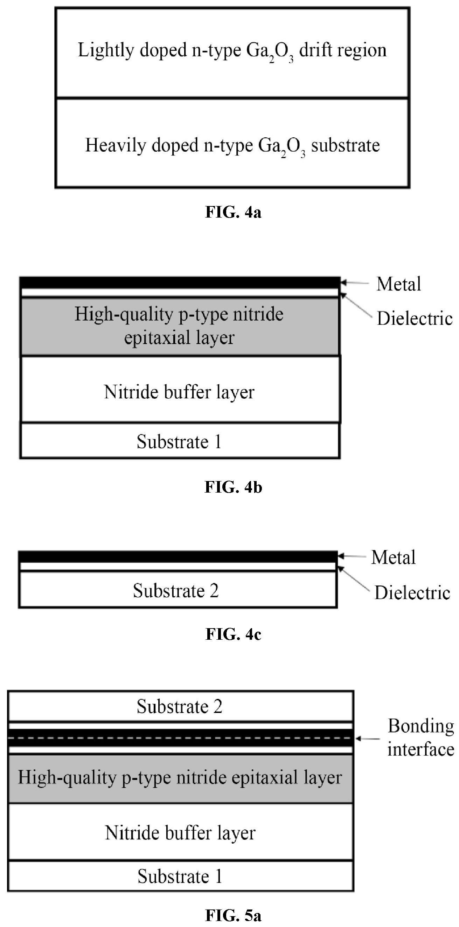

Specifically, a fabrication method for the vertical-type gallium oxide device includes the following steps.
(1) A lightly doped n- Ga₂O₃ drift region is grown on a heavily doped n- Ga₂O₃ substrate by using epitaxial techniques such as metal-organic chemical vapor deposition (MOCVD), molecular beam epitaxy (MBE), or hydride vapor phase epitaxy (HVPE), as shown in FIG. 4a.

A stacked nitride buffer layer and a high-quality p-type nitride epitaxial layer are grown on Substrate 1 (that is, the first substrate, the same hereinafter), and then an insulating dielectric layer (SiO₂, SiN, Al₂O₃, BN, and the like) is deposited on a surface of the p-type nitride epitaxial layer by using dielectric layer deposition techniques such as atomic layer deposition (ALD), or chemical vapor deposition (CVD), and a metal (Au, Cu, Al, and the like) is deposited on the insulating dielectric layer by using metal deposition techniques such as electron beam evaporation or sputtering, as shown in FIG. 4b.

Specifically, Substrate 1 may be made of Si, sapphire, GaN, BN, graphene, and the like, the nitride buffer layer may include AlN, and the like; and the nitride buffer layer can alleviate lattice mismatch to reduce the influence of interface states, thereby obtaining a high-quality epitaxial layer. The p-type nitride epitaxial layer may include p-GaN, p-AlGaN, p-InGaN, or various combinations thereof. A doping concentration of the p-type nitride epitaxial layer may be either uniform or graded. In a case that the doping concentration of the p-type nitride epitaxial layer is graded, a high doping concentration is adopted first during epitaxy, followed by a lower concentration. Activation of p-type impurities in the p-type nitride epitaxial layer may be carried out in multiple steps: activation in an epitaxial chamber, activation after bonding, activation after heterojunction formation, or activation after full device fabrication.

An insulating dielectric layer (SiO₂, SiN, Al₂O₃, BN, and the like) is deposited on Substrate 2 by using dielectric layer deposition techniques such as atomic layer deposition (ALD), or chemical vapor deposition (CVD), and a metal (Au, Cu, Al, and the like) is deposited on the insulating dielectric layer by using metal deposition techniques such as electron beam evaporation or sputtering, as shown in FIG. 4c. Epitaxial growth separate on Substrate 1 and Substrate 2 allows higher-quality material layers to be obtained on their respective suitable substrates, based on existing epitaxial growth techniques.

(2) Metal surfaces of the structures in FIG. 4b and FIG. 4c are integrally bonded by using a low-temperature bonding mode, as shown in FIG. 5a, where a bonding temperature is 350°C.

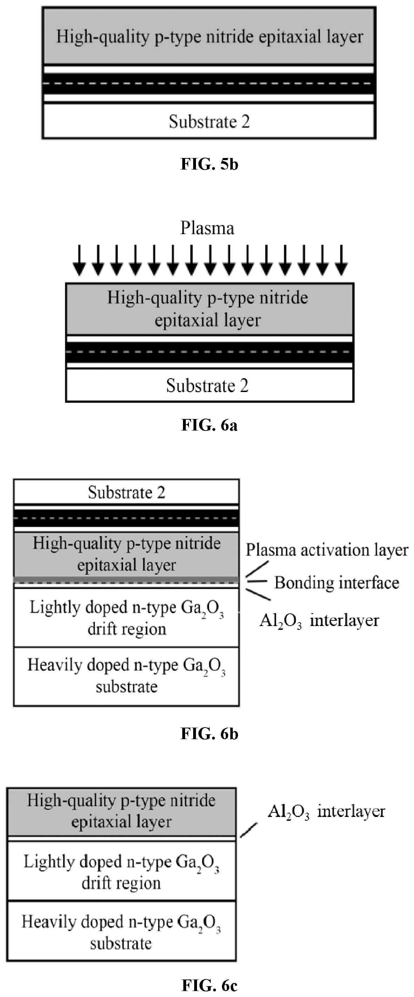

Substrate 1 is entirely removed by removed by etching lift-off (for example, a deep silicon etching process), laser lift-off, or direct lift-off. Subsequently, the nitride buffer layer is removed by using a high-selectivity chemical mechanical polishing (CMP) grinding and polishing process, leaving merely a high-quality p-type nitride epitaxial layer, as shown in FIG. 5b. The chemical mechanical polishing (CMP) grinding and polishing process adopts a white polishing pad under the conditions of 6 kg and 120 min, the polishing solution may include: H₂O at a ratio of 1:1, and NaOH- SiO₂ particles with a pH value of approximately 10.

(3) An inductively coupled plasma etcher is configured to carry out plasma activation surface treatment on the p-type nitride epitaxial layer using low-damage H plasma or N plasma, as shown in FIG. 6a. Specifically, when H plasma is used for carrying out plasma activation surface treatment on the p-type nitride epitaxial layer, H₂ flow rate is 30 sccm, RF power is 2 W, ICP power is 300 W, a temperature is 25°C, a pressure is 8 mTorr, and a DC bias is 10 V.

A layer of Al with a thickness of 1 to 5 nm is deposited on a surface of the lightly doped n-Ga₂O₃ drift region by using an electron beam deposition process, and Al is oxidized as an Al₂O₃ interlayer by means of ultraviolet ozone treatment.

The p-type nitride epitaxial layer after activation surface treatment is directly bonded to the Ga₂O₃ epitaxial structure with an Al₂O₃ interlayer on the surface, as shown in FIG. 6b, where Al element is diffused from the Al₂O₃ interlayer into the lightly doped n-Ga₂O₃ drift region during high-pressure bonding, a diffusion depth and concentration are affected by a duration and pressure level of the high-pressure process, and a greater diffusion depth can be achieved under a higher pressure and longer duration, which is highly beneficial for improving quality of a bonding interface. In addition, the Al₂O₃ interlayer can also serve as an i layer in a p-GaN/Al₂O₃/n-Ga₂O₃ PIN structure, which further widens a width of the depletion region, thereby enhancing voltage withstand performance of the device. The thickness of the Al₂O₃ interlayer may also indirectly affect a carrier concentration through the effects of interface defects or interface charges, and can effectively increase a carrier concentration, thereby reducing the on-resistance of the device. Therefore, a relatively thin Al₂O₃ interlayer is preferred. A thicker aluminum oxide layer may screen the electric field, reduce carrier transport, and lead to a decrease in carrier concentration. Certainly, the Al₂O₃ interlayer may also be replaced with the AlN interlayer.

It needs to be noted that aluminum oxide formed by oxidation generally exhibits directionality and can alleviate lattice mismatch between materials.

(4) Substrate 2, as well as the insulating dielectric layer and bonding metal between the p-type nitride epitaxial layer and Substrate 2, is removed, obtaining an epitaxial structure of the p-type nitride epitaxial layer/Al₂O₃ interlayer/n-Ga₂O₃ drift region/heavily doped n⁺-Ga₂O₃ substrate, as shown in FIG. 6c.

The insulating dielectric layer between Substrate 2 and the p-type nitride epitaxial layer may employ SiN, SiO₂, or a composite dielectric of the two, which can be etched and removed using a BOE (buffered oxide etching) etchant.

(5) Metal deposition processes such as electron beam evaporation or sputtering are employed to deposit metal on the surface of the p-type nitride epitaxial layer and a back surface of the heavily doped n⁺-Ga₂O₃ substrate, respectively, and then annealing is carried out to form an ohmic contact, thereby obtaining a pn heterojunction diode.

According to the present disclosure, a high-quality p-type nitride layer and a high-quality n-type gallium oxide layer are epitaxially grown separately, and then a high-quality p-type nitride/n-type gallium oxide heterojunction material structure and a pn heterojunction device are achieved by low-temperature bonding. The device features excellent process compatibility, can achieve large-scale device fabrication, and improves uniformity and reliability of the device.

According to the present disclosure, a gallium oxide pn heterojunction diode can be effectively achieved. For both p-type and n-type epitaxial layers, high quality and controllable epitaxy can be achieved, thereby avoiding device uniformity and reliability problems caused by insufficient crystal quality, poor controllability, and other related problems. A low-temperature bonding process ensures strong process compatibility. As the p-type nitride epitaxial layer can be epitaxially grown over a large area on a Si substrate, efficient large-scale device fabrication can be achieved. The method for forming the pn heterojunction is flexible and convenient, enabling implementation of a complex device structure.

According to the present disclosure, during high-pressure bonding, the Al₂O₃/AlN interlayer releases Al atoms that diffuse into the lightly doped n-Ga₂O₃ drift region. This not only improves bonding interface quality but also increases a carrier concentration and reduces on-resistance of the device. In addition, a depletion region is further expanded, thereby enhancing voltage withstand performance of the device.

It should be understood that the foregoing embodiments are merely used to describe the technical concepts and features of the present disclosure, and are intended to enable a person skilled in the art to understand and implement the content of the present disclosure, which is not intended to limit the scope of protection of the present disclosure. Any equivalent change or modification made in accordance with the spirit of the present disclosure shall fall within the scope of protection of the present disclosure.

## Claims

1. A vertical-type gallium oxide device, comprising an epitaxial structure, and a cathode and an anode that are matched to the epitaxial structure, wherein the epitaxial structure comprises a heavily doped n-type Ga₂O₃ substrate, a lightly doped n-type Ga₂O₃ drift region, an interlayer, and a p-type nitride epitaxial layer that are arranged in a stacked sequence; the lightly doped n-type Ga₂O₃ drift region, the interlayer and the p-type nitride epitaxial layer form a p-i-n structure, the cathode forms an ohmic contact with the heavily doped n-type Ga₂O₃ substrate, and the anode forms an ohmic contact with the p-type nitride epitaxial layer; the interlayer comprises an Al-containing compound, and a surface region that is of the lightly doped n-type Ga₂O₃ drift region and that is close to the interlayer also contains an Al element, wherein the Al element is diffused from the interlayer into the lightly doped n-type Ga₂O₃ drift region during high-pressure bonding.

2. The vertical-type gallium oxide device according to claim 1, wherein the interlayer is an Al₂O₃ interlayer or an AlN interlayer.

3. The vertical-type gallium oxide device according to claim 1 or 2, wherein the interlayer has a thickness of 1 nm to 5 nm.

4. The vertical-type gallium oxide device according to claim 1, wherein the p-type nitride epitaxial layer comprises at least one or a combination of two or more of p-GaN, p-AlGaN, and p-InGaN;
preferably, the p-type nitride epitaxial layer has a thickness of 10 nm to 1 µm;
preferably, p-type impurities in the p-type nitride epitaxial layer are in uniform distribution or gradient distribution; and
preferably, a doping concentration of the p-type impurities in the p-type nitride epitaxial layer gradually decreases from one side that is of the p-type nitride epitaxial layer and that is close to the interlayer to one side that is close to the anode.

5. The vertical-type gallium oxide device according to claim 1, wherein a dielectric layer is further disposed between the p-type nitride epitaxial layer and the anode, the dielectric layer comprises any one or a combination of two or more of AlN, Al₂O₃, and BN, and the dielectric layer has a thickness of 1 nm to 10 nm.

6. A fabrication method for a vertical-type gallium oxide device, comprising the following steps:
providing a first epitaxial structure, wherein the first epitaxial structure comprises a heavily doped n-type Ga₂O₃ substrate, a lightly doped n-type Ga₂O₃ drift region, and an interlayer that are arranged in a stacked manner, and the interlayer comprises an Al-containing compound;
providing a second epitaxial structure, wherein the second epitaxial structure comprises a p-type nitride epitaxial layer, and carrying out plasma surface activation treatment on the p-type nitride epitaxial layer;
directly bonding the interlayer of the first epitaxial structure to the p-type nitride epitaxial layer of the second epitaxial structure, wherein the lightly doped n-type Ga₂O₃ drift region, the interlayer, and the p-type nitride epitaxial layer form a p-i-n structure, and during bonding, a part of Al in the interlayer is diffused into a surface region that is of the lightly doped n-type Ga₂O₃ drift region and that is close to the interlayer; and
forming a cathode on a back surface of the heavily doped n-type Ga₂O₃ substrate, and forming an anode on a surface of the p-type nitride epitaxial layer.

7. The fabrication method for the vertical-type gallium oxide device according to claim 6, comprising:
providing a first substrate, growing a nitride buffer layer on the first substrate, growing the p-type nitride epitaxial layer on the nitride buffer layer, forming a first insulating dielectric layer on the p-type nitride epitaxial layer, and forming a first metallic layer on the first insulating dielectric layer;
providing a second substrate, forming a second insulating dielectric layer on the second substrate, and forming a second metallic layer on the second insulating dielectric layer;
integrally bonding the first metallic layer and the second metallic layer;
removing the first substrate and the nitride buffer layer, and taking a remaining portion as the second epitaxial structure; and
after directly bonding the interlayer of the first epitaxial structure to the p-type nitride epitaxial layer of the second epitaxial structure, removing a portion of the second epitaxial structure other than the p-type nitride epitaxial layer.

8. The fabrication method for the vertical-type gallium oxide device according to claim 6, wherein the interlayer is an Al₂O₃ interlayer or an AlN interlayer, preferably, the interlayer has a thickness of 1 nm to 5 nm;
preferably, the fabrication method specifically comprises: forming the lightly doped n-type Ga₂O₃ drift region on the heavily doped n-type Ga₂O₃ substrate, forming an Al layer on the lightly doped n-type Ga₂O₃ drift region, and oxidizing the Al layer to form an Al₂O₃ interlayer.

9. The fabrication method for the vertical-type gallium oxide device according to claim 6, wherein the p-type nitride epitaxial layer comprises at least one or a combination of two or more of p-GaN, p-AlGaN, and p-InGaN;
preferably, the p-type nitride epitaxial layer has a thickness of 10 nm to 1 µm;
preferably, p-type impurities in the p-type nitride epitaxial layer are in uniform distribution or gradient distribution; and
preferably, a doping concentration of the p-type impurities in the p-type nitride epitaxial layer gradually decreases from one side that is of the p-type nitride epitaxial layer and that is close to the interlayer to one side that is close to the anode.

10. The fabrication method for the vertical-type gallium oxide device according to claim 6, further comprising: forming a dielectric layer on the p-type nitride epitaxial layer, and then fabricating the anode on the dielectric layer, wherein the dielectric layer comprises any one or a combination of two or more of AlN, Al₂O₃, and BN, and the dielectric layer has a thickness of 1 nm to 10 nm.
